# DEMANDE DE BREVET EUROPEEN

(11) **EP 3 358 251 A1**
(43) Date de publication de la demande: **08.08.2018**
(21) Numéro de dépôt: 17210161.0
(22) Date de dépôt: 22.12.2017
(51) Int. Cl.: F21V 9/08

(54) **DISPOSITIF À FONCTION DE SIGNALISATION LUMINEUSE**

(30) Priorité: 01.02.2017 FR 1750830
(71) Demandeur: Schneider Electric Industries SAS, 92500 Rueil-Malmaison (FR)
(72) Inventeur: FORT, Thierry, 16130 Gimeux (FR); THIZON, Patrice, 16600 Ruelle sur Touvre (FR); POUYOLLON, Marcel, 16160 Gond Pontouvre (FR); LORRAIN, Sophie, 16600 Momac (FR); YOUSFI, Youssef, 16400 Puymoyen (FR)
(74) Mandataire: Dufresne, Thierry

(57) **Abrégé**

L'invention concerne un dispositif à fonction de signalisation lumineuse comprenant :
- Une diode électroluminescente (120) destinée à émettre un premier signal lumineux (S1) dans une première gamme de longueur d'ondes (L1) dans le bleu ou l'ultra-violet,
- Des moyens de conversion agencés pour convertir ledit premier signal lumineux (S1) émis par la diode électroluminescente dans ladite première gamme de longueur d'onde en un deuxième signal lumineux (S2) situé dans une deuxième gamme de longueur d'ondes (L2),
- Un cabochon (11) agencé pour filtrer ledit deuxième signal lumineux (S2) en vue d'obtenir une couleur comprise dans une zone de couleurs normalisées,
- Les moyens de conversion étant choisis de manière à ce que ladite deuxième gamme de longueur d'onde (L2) comporte ladite zone de couleurs normalisées.

## Description

### Domaine technique de l'invention

La présente invention se rapporte à un dispositif incluant une fonction de signalisation lumineuse.

### Etat de la technique

Un dispositif, incluant une fonction de signalisation lumineuse et couramment employé dans le domaine industriel, est par exemple fixé à travers un panneau formé de la porte d'une armoire électrique ou d'un pupitre de commande. Il se compose en règle générale d'au moins deux parties. Une première partie comporte un bloc lumineux doté d'une source lumineuse. Une deuxième partie comporte le corps du dispositif sur lequel est fixé un cabochon à travers lequel est émis le signal lumineux produit par la source lumineuse. Le dispositif peut comporter une troisième partie formée d'une embase qui permet d'effectuer la liaison mécanique entre le corps du dispositif et le bloc lumineux.

Désormais, pour différentes raisons, notamment d'encombrement et de durée de vie, les blocs lumineux utilisent comme source lumineuse une ou plusieurs diodes électroluminescentes. Chaque diode électroluminescente émet un signal lumineux compris dans une gamme de longueur d'ondes déterminée.

Dans un dispositif à fonction de signalisation lumineuse, l'obtention de la couleur émise est réalisée classiquement par la combinaison de la couleur émise par la diode électroluminescente et par le cabochon qui est chargé de filtrer le signal émis par la diode afin d'obtenir une lumière dans une gamme de longueur d'ondes comprise dans une zone de couleur normalisée.

Pour obtenir les différentes couleurs prévues par la norme, il est aujourd'hui nécessaire d'avoir plusieurs blocs lumineux distincts ainsi que plusieurs cabochons de couleurs distinctes afin d'obtenir les couleurs classiques normalisées, c'est-à-dire notamment le blanc, le vert, le rouge et le bleu.

Un dispositif à fonction de signalisation lumineuse ayant cette configuration est fixé dans une ouverture de diamètre standard réalisée à travers un panneau. Le corps du dispositif traverse l'ouverture pour venir en appui contre la face avant du panneau, laissant visible le cabochon sur l'avant du panneau. L'embase est fixée par l'arrière et permet d'assurer la fixation du corps dans l'ouverture grâce à des moyens de fixation adaptés. Le bloc lumineux est fixé sur l'embase dans un logement prévu à cet effet. Le bloc lumineux est ainsi placé à l'arrière du panneau, le rendant difficilement accessible. Toute opération sur le bloc lumineux, notamment son remplacement pour obtenir une autre couleur de signalisation, s'avère donc peu pratique à mettre en oeuvre.

Par ailleurs, on comprend que la solution actuelle nécessite de disposer de plusieurs blocs lumineux de couleurs distinctes, en même temps qu'un certain nombre de cabochons pour obtenir les différentes couleurs évoquées ci-dessus. Il est également nécessaire de proposer des combinaisons particulières "bloc lumineux-cabochon" pour assurer l'obtention des différentes couleurs.

Il existe donc un certain nombre de contraintes dans l'utilisation de la solution actuelle, notamment :
- Commerciales, liées au nombre de références à gérer pour chaque bloc lumineux, chaque cabochon et chaque combinaison de bloc lumineux-cabochon ;
- Techniques, liées notamment à l'installation du dispositif et à son remplacement pour obtenir une autre couleur.

Le brevet US6340824B1 décrit une solution de signalisation lumineuse comprenant une diode électroluminescente émettant un signal lumineux primaire, un convertisseur placé au-dessus de la diode pour convertir le signal lumineux primaire en un signal lumineux secondaire, un réflecteur placé au-dessus du convertisseur pour renvoyer une partie du signal lumineux primaire et un absorbeur lumineux placé au-dessus du réflecteur pour sélectionner le signal lumineux secondaire et absorber le signal lumineux primaire. Cette solution a pour but de fournir un signal lumineux stable en longueur d'onde. Son objectif n'est donc pas d'obtenir une couleur particulière comprise dans une zone de couleur normalisée.

Le but de l'invention est donc de proposer un dispositif à fonction de signalisation lumineuse qui permet de pallier les inconvénients de l'état de la technique en proposant une solution permettant d'obtenir une couleur incluse dans une zone de couleur normalisée avec une intensité particulièrement importante.

### Exposé de l'invention

Ce but est atteint par un dispositif à fonction de signalisation lumineuse destiné à émettre un signal lumineux vers l'extérieur dans une zone de couleur dite normalisée, ledit dispositif comprenant :
- Une diode électroluminescente destinée à émettre un premier signal lumineux dans une première gamme de longueur d'ondes dans le bleu ou l'ultra-violet,
- Des moyens de conversion agencés pour convertir ledit premier signal lumineux émis par la diode électroluminescente dans ladite première gamme de longueur d'onde en un deuxième signal lumineux situé dans une deuxième gamme de longueur d'ondes,
- Un cabochon (11) agencé pour sélectionner une gamme particulière de longueur d'ondes plus restreinte dans la deuxième gamme de longueurs d'ondes (L2) de manière à obtenir en sortie un signal (S3) à une troisième longueur d'onde (L3) correspondant à une couleur comprise dans ladite zone de couleur normalisée,
- Les moyens de conversion sont configurés de manière à ce que ladite deuxième gamme de longueur d'onde comporte ladite zone de couleur normalisée.

Ainsi, les moyens de conversion présentent une fonction de conversion agencée pour convertir le premier signal lumineux en un deuxième signal lumineux, ce deuxième signal lumineux incluant la zone de couleur normalisée.

Selon une particularité, les moyens de conversion comportent un élément à fonction luminophore intercalé entre la diode électroluminescente et le cabochon.

Selon une première variante de de réalisation, le dispositif comporte un corps, l'élément à fonction luminophore comportant une première pièce et le cabochon comportant une deuxième pièce, la première pièce et la deuxième pièce étant fixées de manière indépendante sur ledit corps.

Selon une deuxième variante de réalisation, le dispositif comporte un corps, l'élément à fonction luminophore et le cabochon étant assemblées sur le corps sous la forme d'une seule pièce réalisée par bi-injection.

Selon une troisième variante de réalisation, l'élément à fonction luminophore se présente sous la forme d'une couche déposée sur une surface dudit cabochon.

Selon une autre particularité, le dispositif comporte une pièce guide lumière agencée dans le corps du dispositif pour guider le premier signal lumineux vers lesdits moyens de conversion.

Selon une autre particularité, ladite pièce guide lumière est réalisée dans un matériau opaque.

Selon une autre variante de réalisation, l'élément à fonction luminophore comporte une lentille positionnée au-dessus de la diode électroluminescente.

Selon une autre particularité, le dispositif comporte un bloc lumineux comprenant ladite diode électroluminescente.

Selon une autre particularité, le bloc lumineux comporte une carte électronique sur laquelle est soudée ladite diode électroluminescente.

Selon une autre particularité, le bloc lumineux comporte une proéminence dans laquelle est logée ladite diode électroluminescente, ladite proéminence comprenant un élément transparent à travers lequel est émis ledit premier signal lumineux.

Selon une autre particularité, le dispositif comporte une embase comprenant des moyens de fixation dudit bloc lumineux.

Selon une autre particularité, le dispositif comporte également une fonction de commande, réalisée à partir d'un bouton poussoir ou d'un bouton tournant. Le cabochon est alors réalisé par une pièce formant le bouton-poussoir ou le bouton tournant.

### Brève description des figures

D'autres caractéristiques et avantages vont apparaître dans la description détaillée qui suit faite en regard des dessins annexés dans lesquels :
- La figure 1 illustre le principe de fonctionnement de l'invention ;
- La figure 2 représente de manière schématique, le dispositif à fonction de signalisation lumineuse de l'invention ;
- La figure 3A représente un diagramme de chromaticité de type CIE (Commission Internationale de l'Eclairage) permettant d'identifier les couleurs normalisées dans le domaine de la signalisation lumineuse et la figure 3B illustre le principe de l'invention par les spectres lumineux ;
- Les figures 4A à 4C représentent les différentes variantes de réalisation de la solution de l'invention ;
- La figure 5A illustre le principe employé actuellement pour obtenir différentes couleurs dans un dispositif à fonction de signalisation lumineuse classique et la figure 5B permet d'illustrer l'avantage apporté par la solution de l'invention ;
- Les figures 6A et 6B représentent différents modes de réalisation du dispositif à fonction de signalisation lumineuse de l'invention, suivant une vue en éclaté en perspective et suivant une vue en coupe longitudinale axiale.

### Description détaillée d'au moins un mode de réalisation

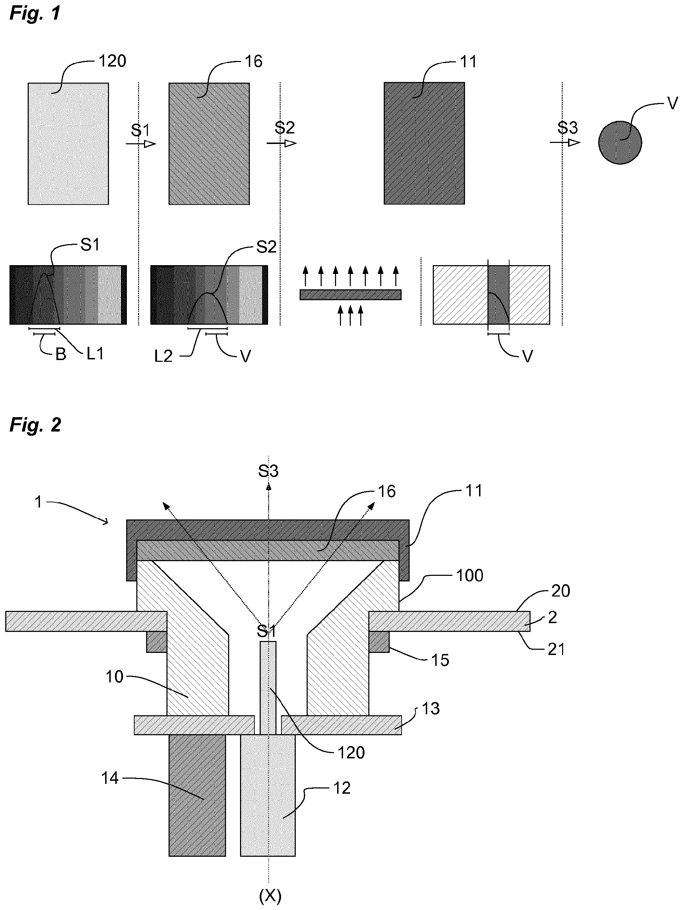

Dans la suite de la description, les termes "haut", "bas", "supérieur", "inférieur", "au-dessus", "au-dessous" sont à comprendre en prenant comme référence l'axe (X, figure 2), visible sur les figures annexées et représenté suivant une direction verticale.

L'invention concerne un dispositif à fonction de signalisation lumineuse. La solution proposée présente un avantage pour un dispositif à fonction de signalisation lumineuse formé d'au moins deux parties séparables entre elles, mais elle pourrait tout à fait s'appliquer à un dispositif se présentant sous une forme monobloc.

De manière non limitative, la solution de l'invention sera décrite ci-dessous pour un dispositif à fonction de signalisation lumineuse qui comporte au moins deux parties séparables entre elles.

En outre, par dispositif à fonction de signalisation lumineuse, il faut comprendre qu'il s'agit de tout dispositif proposant une fonction de signalisation lumineuse. Cela inclut donc les dispositifs présentant également, en plus, une fonction de commande, par exemple les boutons poussoirs ou boutons tournants, dotés en complément d'une fonction de signalisation lumineuse. Pour tous ces dispositifs, le principe de l'invention restera identique. Dans la suite de la description, nous évoquerons de manière générale un dispositif à fonction de signalisation lumineuse.

De manière non limitative, le dispositif comporte typiquement trois parties principales :
- Une première partie comprenant principalement un corps et un cabochon de couleur fixé sur le corps et à travers lequel est diffusée la lumière vers l'extérieur ;
- Une deuxième partie comportant un bloc lumineux 12, avantageusement amovible et doté d'au moins une diode électroluminescente 120 ;
- Avantageusement, une troisième partie formée d'une embase venant se fixer sur le corps de la première partie du dispositif et dotée de moyens de fixation coopérant avec des moyens de fixation correspondants afin de fixer le bloc lumineux.

En référence à la figure 2, le dispositif 1 est monté en s'engageant dans une ouverture formée à travers une paroi 2 métallique, telle que par exemple la porte d'une armoire électrique ou un pupitre de commande. Pour un bouton-poussoir ou tournant, l'ouverture est par exemple de diamètre normalisé par exemple égal à 22 mm. La paroi comporte une première face 20, dite externe, et une deuxième face 21, dite interne.

De manière classique mais non limitative, le dispositif comporte un corps 10 se présentant sous la forme d'une pièce tubulaire autour d'un axe (confondu avec l'axe (X) sur les figures) et destiné à être inséré suivant son axe à travers ladite ouverture de la paroi 2. Suivant son axe, le corps 10 comporte une partie inférieure et une partie supérieure qui peuvent être séparées entre elles par un épaulement. La partie supérieure est dotée d'une collerette 100 annulaire destinée à prendre appui sur une première face, dite face externe, de la paroi 2 autour de l'ouverture, de sorte que sa position délimite, suivant un plan d'appui P contre la face externe 20 de la paroi, la partie visible du dispositif située d'un premier côté de la paroi 2 par rapport à la partie invisible du dispositif située d'un deuxième côté de la paroi 2. Un joint d'étanchéité est par exemple positionné entre la collerette 100 et la surface de la paroi 2. Afin de permettre le passage d'un flux lumineux, le corps est creux suivant l'axe (X). Un flux lumineux généré par le bloc lumineux est apte à traverser le corps pour atteindre la tête du dispositif comportant un cabochon 11. Le corps est avantageusement réalisé dans un matériau opaque et intègre un élément (pièce 17 décrite ci-dessous) en matériau opaque de manière à focaliser le flux lumineux vers le cabochon. De manière non limitative, le corps pourra être réalisé en matériau plastique ou métallique.

Le dispositif comporte des moyens de fixation sur ladite paroi 2. Ces moyens de fixation ne font pas l'objet de la présente demande et ils peuvent être de différentes natures. Les moyens de fixation employés sont par exemple constitués d'un écrou 15 vissé sur un filetage externe réalisé sur la partie inférieure du corps tubulaire du dispositif ou, comme décrits dans le brevet EP0889564B1**,** constitués par une embase qui s'assemble au corps tubulaire, cette embase portant des moyens d'accrochage tels que des vis pointeau ou des bras d'accrochage pivotants manoeuvrés au moyen d'une vis.

Comme décrit ci-dessus, le dispositif comporte également une tête comprenant un cabochon 11 transparent coloré permettant de faire passer un flux lumineux généré par le bloc lumineux. Le cabochon 11 est fixé sur le corps 10 du dispositif.

Lorsque le dispositif comporte également une fonction de commande, il comprend un bouton actionnable et au moins une unité de contacts électriques. L'unité de contacts comporte un ou plusieurs blocs de contact électrique 14. Chaque bloc de contact électrique 14 comporte un interrupteur à contact mobile actionnable par une pression sur le bouton de l'organe de commande. Un bouton d'arrêt d'urgence comporte ainsi au moins un bloc de contact électrique dont l'interrupteur est configuré en mode normalement fermé (NC pour "normally closed" en anglais).

Pour porter l'unité de contacts et ledit bloc lumineux, le dispositif utilise l'embase 13 de fixation, par exemple de forme rectangulaire. Cette embase 13 comporte une ouverture centrale destinée à être traversée par la partie inférieure du corps 10 tubulaire et des moyens de fixation servant à porter de manière amovible les blocs de contacts électriques 14. Selon les configurations, cette embase 13 peut être solidaire des moyens de fixation ou indépendante de ces moyens de fixation. Dans ce dernier cas, la partie inférieure du corps du dispositif vient s'encliqueter dans ladite embase. Dans un dispositif à fonction de commande, l'action sur le bouton vient actionner les interrupteurs des blocs de contact de l'unité de contact, agissant simultanément sur la commande du bloc lumineux pour allumer ou éteindre la diode électroluminescente.

En référence à la figure 1, le principe général de l'invention est le suivant :
- Employer un bloc lumineux 12 toujours identique, c'est-à-dire avec au moins une diode électroluminescente 120 émettant un signal lumineux S1 toujours compris dans la même gamme de longueur d'ondes, quelle que soit la couleur finale à obtenir à travers le cabochon du dispositif ;
- Employer des moyens de conversion permettant de convertir le signal lumineux émis par la diode électroluminescente 120 en un signal lumineux S2 compris dans une deuxième gamme de longueur d'ondes ;
- Filtrer le signal lumineux S2 obtenu en sortie des moyens de conversion par un cabochon 11 de couleur adaptée pour obtenir un signal S3 émis vers l'extérieur à la couleur voulue (par exemple de couleur verte V sur la figure 1).

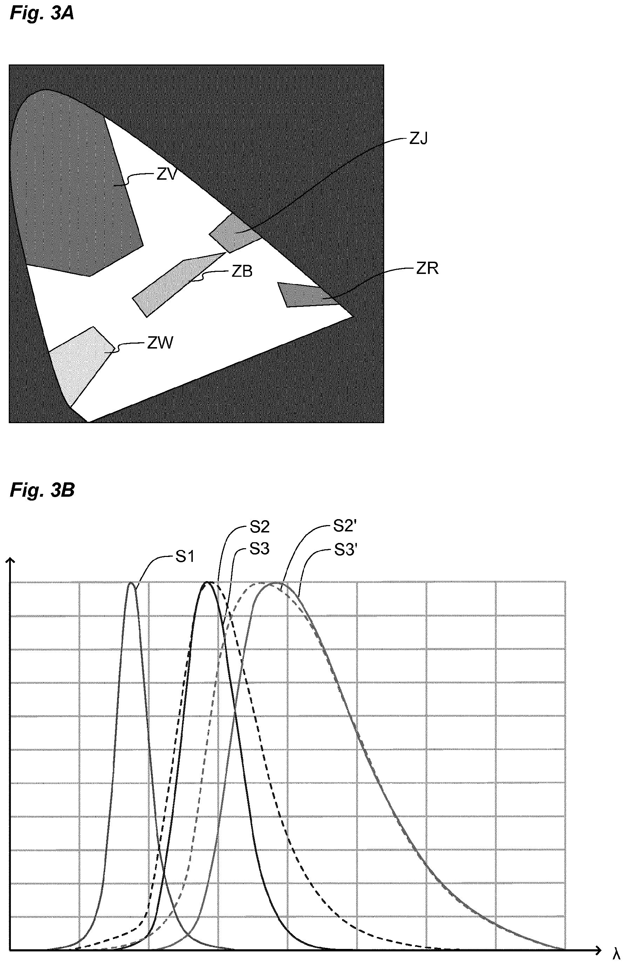

Dans le domaine de la signalisation lumineuse, les couleurs d'émission sont habituellement normalisées. La figure 3A montre un diagramme de chromaticité représentant les différentes zones de couleurs normalisées. Sur cette figure 3A, les zones de couleurs normalisées dans le domaine de la signalisation sont identifiées par les lettres ZV pour le vert, ZB pour le bleu, ZR pour le rouge, ZW pour le blanc, ZJ pour le jaune. De manière connue, un tel diagramme de chromaticité permet d'exprimer chaque couleur à partir de trois coefficients x, y, z correspondant chacun respectivement au niveau d'une couleur parmi les trois couleurs de base que sont le Rouge, le Vert et le Bleu (pour RVB). Chaque zone de couleur normalisée représentée sur la figure 3 est donc définie par une gamme de valeurs prises par les coefficients x, y, z. Une zone de couleur normalisée est donc définie par un ensemble de couleurs comprises dans une zone du diagramme qui est définie par un ensemble de valeurs x, y, z. Chaque zone de couleur normalisée est une zone fermée. Selon un aspect de l'invention, il s'agira d'obtenir en sortie une couleur comprise dans la zone de couleur normalisée voulue (selon la couleur choisie).

De manière plus précise, selon un aspect avantageux de l'invention, le bloc lumineux 12 embarque une diode électroluminescente 120 émettant le signal S1 dans une première gamme de longueur d'ondes L1 située dans le bleu ou l'ultra-violet.

En outre, les moyens de conversion comportent avantageusement un élément 16 à fonction luminophore, permettant de convertir le signal lumineux S1 émis par la diode électroluminescente 120 dans une première gamme de longueur d'ondes L1 en un signal lumineux S2 présent dans une deuxième gamme de longueur d'ondes L2. De manière avantageuse, le matériau luminophore est choisi de sorte que le signal lumineux S2 obtenu dans la deuxième gamme de longueurs d'ondes L2 correspond à une zone de couleur (ou de chromaticité) qui est plus large que ladite zone de couleur normalisée évoquée ci-dessus mais qui inclut ladite zone de couleur normalisée. De ce fait, la couleur obtenue en sortie de l'élément 16 à fonction luminophore, avant filtrage par le cabochon, est proche de la couleur finale souhaitée en sortie du cabochon.

Le cabochon 11 est choisi de manière à filtrer le signal lumineux S2 obtenu en sortie de l'élément 16 à fonction luminophore. Le cabochon 11 est agencé pour sélectionner une gamme particulière de longueur d'ondes plus restreinte dans la deuxième gamme de longueurs d'ondes L2 plus étendue de manière à obtenir en sortie un signal S3 de longueur d'onde L3. Le cabochon peut être réalisé dans un matériau plastique transparent ou translucide.

Autrement dit, les moyens de conversion sont configurés pour convertir le premier signal lumineux S1 en vue d'obtenir un deuxième signal lumineux S2 présentant une couleur définie par une zone de couleur large incluant la zone de couleur normalisée et le cabochon est configuré pour sélectionner dans la zone de couleur large du deuxième signal lumineux la couleur voulue appartenant à la zone de couleur normalisée.

Un matériau luminophore permet de convertir le signal lumineux en augmentant la longueur d'onde du signal. Cela explique pourquoi la diode électroluminescente 120 est avantageusement choisie pour émettre dans le bleu ou l'ultra-violet. En effet, c'est à partir de la couleur bleue ou de l'ultra-violet qu'il est possible d'aller vers les autres couleurs, l'inverse n'étant pas possible.

Ci-dessous quelques références de matériaux luminophores ("datasheet" Intermatix) qui peuvent être utilisés pour réaliser l'élément à fonction luminophore :
- NYAG4752-L ;
- EG2762 ;

En outre, comme l'élément 16 à fonction luminophore est choisi pour obtenir un signal lumineux S2 dans une gamme de longueur d'ondes L2 qui inclut déjà la gamme de longueurs d'ondes normalisée souhaitée en sortie, le cabochon 11 peut être choisi avec un pouvoir filtrant réduit, permettant ainsi d'obtenir un signal lumineux en sortie du cabochon qui est particulièrement intense.

A titre d'exemple, la figure 3B illustre par des courbes le principe de l'invention. Sur cette figure 3B, on peut voir :
- La courbe qui représente le spectre du signal d'émission S1 de couleur bleu émis par la diode électroluminescente 120 du bloc lumineux 12.
- La courbe qui représente le spectre du signal S2 de longueur d'ondes obtenu, après conversion du signal lumineux S1 émis par la diode bleue par un élément à fonction luminophore adapté, et compris dans la zone de couleur verte normalisée.
- La courbe qui représente le spectre du signal S2' de longueur d'ondes obtenu, après conversion du signal lumineux S1 émis par la diode bleue par un élément à fonction luminophore adapté, et compris dans la zone de couleur jaune normalisée.
- La courbe qui représente le signal S3 de spectre de longueur d'ondes obtenu après filtrage par le cabochon du signal lumineux S2 obtenu en sortie de l'élément à fonction luminophore, pour obtenir la couleur verte.
- La courbe qui représente le signal S3' de spectre de longueur d'ondes obtenu après filtrage par le cabochon du signal lumineux S2' obtenu en sortie de l'élément à fonction luminophore, pour obtenir la couleur jaune.

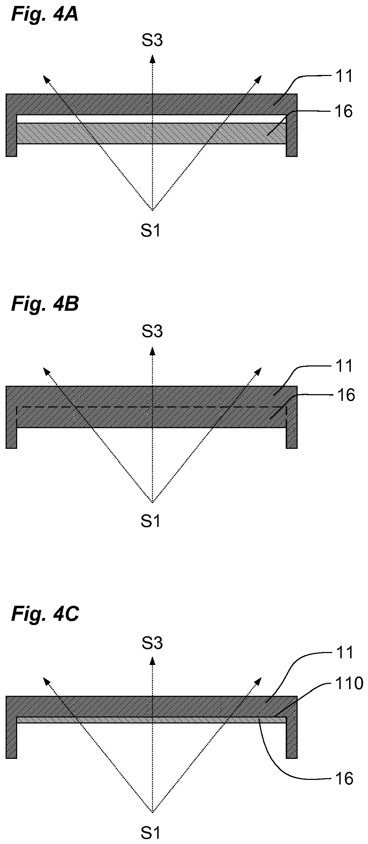

En référence aux figures 4A à 4C, pour la réalisation de la solution de l'invention, plusieurs solutions distinctes peuvent être envisagées :
- Le cabochon 11 et l'élément 16 à fonction luminophore peuvent être réalisés en deux pièces distinctes (figure 4A).
- Le cabochon 11 et l'élément 16 à fonction luminophore peuvent être réalisés en une seule pièce, par exemple réalisée par bi-injection (figure 4B).
- L'élément 16 à fonction luminophore est formé d'une couche de matériau déposée sur la surface interne 110 du cabochon 11 (figure 4C). Le dépôt pourra être réalisé par toute solution adaptée, pulvérisation d'un spray, enduction d'une peinture...
- L'élément à fonction luminophore est constitué d'une lentille en matériau luminophore ou disposant d'une couche en matériau luminophore déposée sur une pièce. Cette lentille est positionnée au plus près de la source lumineuse formée par la diode électroluminescente 120. En suivant un trajet rectiligne suivant l'axe (X), elle est par exemple située plus proche de la diode que du cabochon, préférentiellement à une distance inférieure à 5% de la distance totale allant de la diode au cabochon suivant ledit trajet rectiligne. Cette solution présenterait l'avantage de proposer un élément à fonction luminophore d'une surface équivalente à celle d'émission de la diode électroluminescente 120.

L'élément 16 à fonction luminophore devra être intercalé entre le cabochon 11 et la source lumineuse (diode 120) et capter le signal lumineux S1 émis par la source lumineuse, avec un minimum de fuite.

Entre la source lumineuse et l'élément 16 à fonction luminophore, le dispositif comporte avantageusement une paroi latérale opaque pour canaliser le flux lumineux avec un minimum de perte. Selon le type de dispositif, cette paroi latérale opaque sera par exemple formée par une pièce 17 (17A, 17B, 17C) chargée de guider un maximum de lumière jusqu'à l'élément 16 à fonction luminophore. En cas d'utilisation d'un élément à fonction luminophore sous la forme d'une lentille, celle-ci sera positionnée au plus près de la source, comme explicité ci-dessus, permettant de minimiser les pertes de flux lumineux.

Entre l'élément 16 à fonction luminophore et le cabochon 11, le flux lumineux devra également être canalisé pour se focaliser sur le cabochon 11. Selon la configuration adoptée, l'élément 16 à fonction luminophore sera donc situé au plus près du cabochon 11 pour minimiser la perte de flux lumineux entre ces deux éléments. Pour cela, comme décrit ci-dessus, il sera possible de réaliser l'élément 16 à fonction luminophore et le cabochon 11 en une seule pièce par bi-injection (figure 4B), permettant d'assurer un transfert direct du flux lumineux de l'élément à fonction luminophore vers le cabochon avec un minimum de pertes ou de déposer directement l'élément 16 à fonction luminophore sous la forme d'une couche (par exemple un spray) sur la face interne du cabochon 11 (figure 4C).

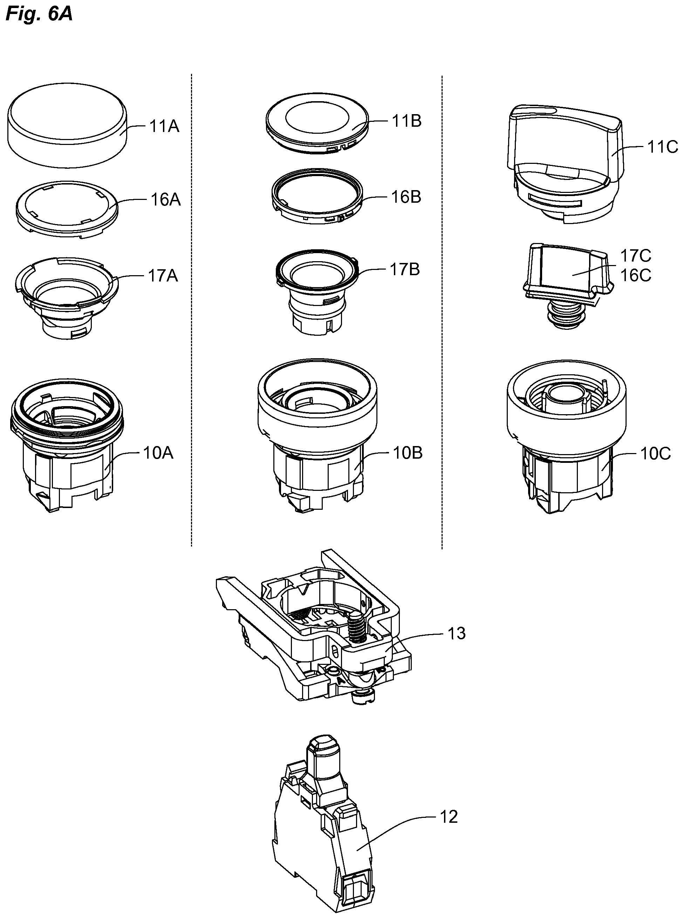

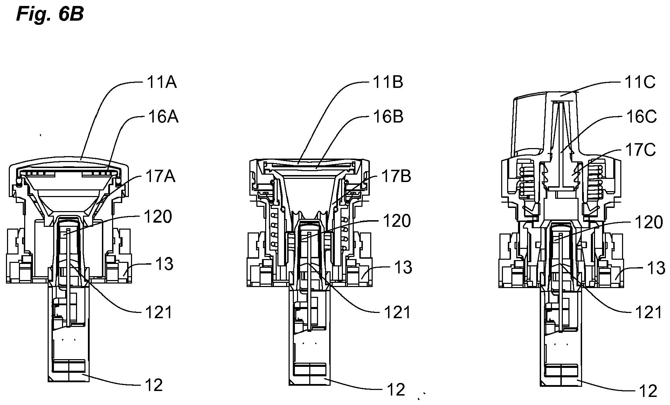

Les figures 6A et 6B illustrent, pour différentes architectures de dispositifs, différentes solutions de mise en oeuvre de l'invention. Les différentes configurations de réalisation de la solution, décrites ci-dessus en liaison avec les figures 4A à 4C, ainsi que la réalisation sous forme de lentille, restent valables dans ces différentes architectures.

Sur ces figures 6A et 6B, la première configuration montre un dispositif comprenant la fonction de signalisation lumineuse réalisée par l'invention et une fonction de commande réalisée par un bouton poussoir. Dans cette application, le cabochon 11A est réalisé par le bouton de commande du dispositif. L'élément 16A à fonction luminophore se compose d'une pièce logée sous le cabochon. Une pièce 17A en forme d'entonnoir logée dans le corps, permet notamment de canaliser le flux lumineux en direction de l'élément 16A à fonction luminophore et du cabochon 11A. Cette pièce 17A est avantageusement réalisée dans un matériau opaque, c'est-à-dire qu'elle ne laisse pas passer la lumière.

La deuxième configuration représente un dispositif comprenant uniquement la fonction de signalisation lumineuse. De même, l'élément 16B à fonction luminophore se compose d'une pièce logée sous le cabochon 11B. Une pièce 17B en forme d'entonnoir logée dans le corps, permet notamment de canaliser le flux lumineux en direction de l'élément 16B à fonction luminophore et du cabochon 11B. Cette pièce 17B est avantageusement réalisée dans un matériau opaque, c'est-à-dire ne laissant pas passer la lumière.

La troisième configuration représente un dispositif comprenant la fonction de signalisation lumineuse réalisée par l'invention et une fonction de commande réalisée par un bouton tournant comprenant une oreille actionnable. Dans cette application, le cabochon 11C est réalisé par le bouton de commande rotatif du dispositif. L'élément 16C (figure 6B) à fonction luminophore se compose d'une pièce comprenant une base et une oreille venant se loger dans le creux formé par un pièce guide lumière 17C agencée pour se loger dans l'oreille actionnable du bouton tournant. Le flux lumineux est canalisé en direction du cabochon (11C) au moins en partie par le corps réalisé dans un matériau opaque. Le flux lumineux émis est visible dans toutes les directions et notamment sur les côtés du dispositif.

Sur les figures 6A et 6B, on peut voir que le bloc lumineux 12 est toujours identique quelle que soit le dispositif. Ce bloc 12 comporte la diode électroluminescente 120, par exemple soudée sur une carte 121 de circuit imprimé logée dans le bloc, dans le sens de la longueur. Le bloc pourra comporter dans sa partie supérieure une proéminence dotée d'un élément en matériau transparent (laissant passer la lumière émise par le signal S1) par lequel est émis le signal lumineux S1. Lorsque le bloc est fixé sur l'embase 13, cette proéminence est destinée à traverser l'ouverture formée à travers l'embase 13 et à venir s'engager dans le canal axial du corps 10 du dispositif 1 afin d'émettre le signal lumineux directement dans le corps 10 du dispositif 1 avec le minimum de pertes. Le signal lumineux S1 émis sera ensuite par exemple guidé vers le cabochon 11 grâce au guide formé par la pièce 17.

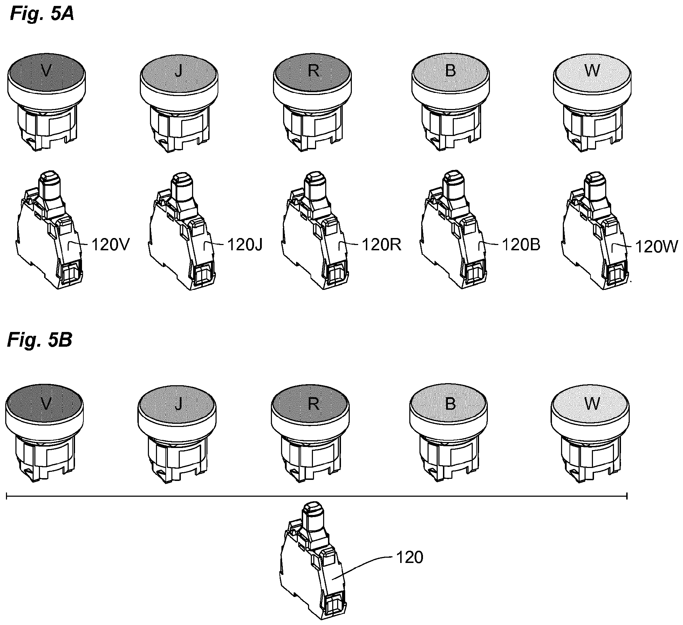

En référence aux figures 5A et 5B, on comprend que la solution de l'invention permet d'apporter un certain nombre d'avantages. Outre le fait d'obtenir une signalisation de meilleure qualité, avec une intensité plus élevée, elle permet de faciliter l'emploi de tels dispositifs de signalisation, en proposant un bloc lumineux 12 toujours identique et l'obtention d'une couleur finale en choisissant simplement le cabochon adapté. La figure 5A représente en effet la configuration actuelle dans laquelle un bloc lumineux distinct (120V pour obtenir le vert, 120J pour le jaune, 120R pour le rouge, 120B pour le bleu, 120W pour le blanc) avec une diode de couleur distincte doit être associée à un cabochon de couleur adaptée (V pour le vert, J pour le jaune, R pour le rouge, B pour le bleu, W pour le blanc) pour obtenir la couleur voulue. La figure 5B représente la solution de l'invention employant un seul bloc lumineux (120) doté d'une diode électroluminescente de couleur bleue pour obtenir toutes les couleurs souhaitées en sortie (V, J, R, B, W) en employant les moyens de conversion et le cabochon adaptés.

## Revendications

1. Dispositif à fonction de signalisation lumineuse destiné à émettre un signal lumineux vers l'extérieur à une couleur comprise dans une zone de couleur dite normalisée, ledit dispositif comprenant :
- Une diode électroluminescente (120) destinée à émettre un premier signal lumineux (S1) dans une première gamme de longueur d'ondes (L1) dans le bleu ou l'ultra-violet,
- Des moyens de conversion agencés pour convertir ledit premier signal lumineux (S1) émis par la diode électroluminescente dans ladite première gamme de longueur d'onde en un deuxième signal lumineux (S2) situé dans une deuxième gamme de longueur d'ondes (L2),
- Un cabochon (11) agencé pour sélectionner une gamme particulière de longueur d'ondes plus restreinte dans la deuxième gamme de longueurs d'ondes (L2) de manière à obtenir en sortie un signal (S3) à une troisième longueur d'onde (L3) correspondant à une couleur comprise dans ladite zone de couleur normalisée,
- **Caractérisé en ce que** :
- Les moyens de conversion sont configurés de manière à ce que ladite deuxième gamme de longueur d'onde (L2) comporte ladite zone de couleur normalisée.

2. Dispositif selon la revendication 1, **caractérisé en ce que** les moyens de conversion comportent un élément (16) à fonction luminophore intercalé entre la diode électroluminescente (120) et le cabochon (11).

3. Dispositif selon la revendication 2, **caractérisé en ce qu'**il comporte un corps (10) et **en ce que** l'élément à fonction luminophore (16) comporte une première pièce et le cabochon (11) comporte une deuxième pièce, la première pièce et la deuxième pièce étant fixées de manière indépendante sur ledit corps (10).

4. Dispositif selon la revendication 2, caractérisé en qu'il comporte un corps (10) et en ce que l'élément à fonction luminophore (16) et le cabochon (11) sont assemblées sur le corps sous la forme d'une seule pièce réalisée par bi-injection.

5. Dispositif selon la revendication 2, **caractérisé en ce que** l'élément à fonction luminophore (16) se présente sous la forme d'une couche déposée sur une surface (110) dudit cabochon (11).

6. Dispositif selon l'une des revendication 3 à 5, **caractérisé en ce qu'**il comporte une pièce (17A, 17B) guide lumière agencée dans le corps du dispositif pour guider le premier signal lumineux (S1) vers lesdits moyens de conversion.

7. Dispositif selon la revendication 6, **caractérisé en ce que** ladite pièce (17A, 17B) guide lumière est réalisée dans un matériau opaque.

8. Dispositif selon la revendication 2, **caractérisé en ce que** l'élément à fonction luminophore comporte une lentille positionnée au-dessus de la diode électroluminescente (120).

9. Dispositif selon l'une des revendications 3 à 8, **caractérisé en ce qu'**il comporte un bloc lumineux (12) comprenant ladite diode électroluminescente (120).

10. Dispositif selon la revendication 9, **caractérisé en ce que** le bloc lumineux comporte une carte (121) électronique sur laquelle est soudée ladite diode électroluminescente (120).

11. Dispositif selon la revendication 9 ou 10, **caractérisé en ce que** le bloc lumineux comporte une proéminence dans laquelle est logée ladite diode électroluminescente (120), ladite proéminence comprenant un élément transparent à travers lequel est émis ledit premier signal lumineux (S1).

12. Dispositif selon l'une des revendications 9 à 11, **caractérisé en ce qu'**il comporte une embase (13) comprenant des moyens de fixation dudit bloc lumineux.

13. Dispositif selon l'une des revendications 1 à 12, **caractérisé en ce qu'**il comporte une fonction de commande, réalisée à partir d'un bouton poussoir ou d'un bouton tournant.

14. Dispositif selon la revendication 13, **caractérisé en ce que** le cabochon (11) est réalisé par une pièce formant le bouton-poussoir ou le bouton tournant.

15. Dispositif selon l'une des revendications 1 à 14, **caractérisé en ce que** la zone de couleur normalisée est choisie parmi une zone de couleur verte (ZV), une zone de couleur rouge (ZR), une zone de couleur bleue (ZB), une zone de couleur blanche (ZW) et une zone de couleur jaune (ZJ).
